# EUROPEAN PATENT APPLICATION

(11) **EP 0 818 809 A2**
(43) Date of publication of application: **14.01.1998**
(21) Application number: 97303829.2
(22) Date of filing: 04.06.1997
(51) Int. Cl.: H01L 21/306

(54) **Method of washing semiconductor wafers**

(30) Priority: 13.06.1996 JP 152598/96; 15.05.1997 US 857056
(71) Applicant: MEMC Electronic Materials, Inc., St. Peters, Missouri 63376 (US)
(72) Inventor: Iwamoto, Yoshio, Tochigi Prefecture, 321-32 (JP); Sato, Masanori, Tochigi Prefecture, 321-32 (JP)
(74) Representative: W.P. THOMPSON & CO.

(57) **Abstract**

A method for washing a semiconductor wafer (1) after polishing and before depositing an epitaxial layer (5) on the wafer by chemical vapor deposition to remove foreign material (2) and prevent growth of foreign material (4). The method includes the steps of washing the semiconductor wafer (1) with a washing agent to remove foreign material (2) from the wafer, and acid pickling the washed semiconductor wafer (1) with an acid to further remove foreign material (2, 3) and to neutralize residual foreign material (3). Thus, the amount and size of foreign material (3, 4) embedded in the epitaxial layer is minimized.

## Description

### Background of the Invention

The present invention relates to a method for washing a semiconductor wafer, and more particularly to a method including an acid pickling step for removing foreign material from the wafer and inhibiting growth of residual foreign material, thereby reducing the potential for defects in an epitaxial layer subsequently deposited on the wafer.

Semiconductor wafers are sliced from single crystal silicon ingots, lapped, etched and polished to provide a smooth surface. An epitaxial layer is deposited on the polished surface by conventional chemical vapor deposition to give the wafer the desired electrical characteristics. The epitaxial layer must have a smooth surface to achieve the desired characteristics.

Following the polishing operation, abrasive and liberated silicon adhere to the surface of the wafers. To remove the abrasive and silicon debris, as well as metal oxides (e.g., alumina chips), ionic compounds and organic matter which may have collected, the wafers are typically washed after the polishing step. During conventional washing operations, the silicon wafers are washed with a washing agent such as one prepared by diluting ammonia hydrogen peroxide with super deionized water. Although these agents work well to remove the abrasive and silicon debris, they do not remove foreign material such as ionized salts. The particles of foreign material remaining on the semiconductor wafer after the washing operation tend to grow over time. Over a period of one month or more, the particles can grow to an unacceptable size.

Although a sufficiently smooth epitaxial layer can be deposited on a surface having small particles, larger particles (e.g., those 0.2µm or larger) cause significant surface discontinuities in the epitaxial layer. These discontinuities adversely affect the properties of semiconductor devices made from the wafers. Moreover, semiconductor users are demanding wafers having smoother surface finishes and smaller defects. Therefore, minimizing the size and number of foreign material particles on wafers prior to chemical vapor deposition is essential to mass production of high quality wafers. Further, minimizing particle growth permits wafers to be stored between polishing and chemical vapor deposition, thereby increasing the process versatility.

### Summary of the Invention

Among the several objects and features of the present invention may be noted the provision of a method for removing foreign material from a semiconductor wafer prior to depositing an epitaxial layer on the wafer; the provision of a method of preventing growth of foreign material to minimize the amount and size of foreign material embedded in the epitaxial layer; the provision of a method which reduces the number of surface defects in the epitaxial layer; and the provision of a method which increases process versatility.

Briefly, the method of the present invention comprises the steps of washing the semiconductor wafer with a washing agent to remove foreign material from the wafer, and acid pickling the washed semiconductor wafer in an acid to further remove foreign material and to neutralize residual foreign material. Thus, the amount and size of foreign material embedded in the epitaxial layer is minimized.

Other objects and features of the invention will be in part apparent and in part pointed out hereinafter.

### Brief Description of the Drawings

Fig. 1(A) is a schematic of a semiconductor wafer processed by conventional washing and chemical vapor deposition, wherein view (a) is the wafer before washing, view (b) is immediately following washing, view (c) is after storage, and view (d) is after chemical vapor deposition;
Fig. 1(B) is a schematic of a semiconductor wafer processed according to the present invention, wherein view (a) is the wafer before washing, view (b) is immediately following washing and acid pickling, view (c) is after storage, and view (d) is after chemical vapor deposition; and
Fig. 2 is graph showing the number of particles 0.2 µm or larger on finished wafers for various hydrochloric acid concentrations of the acid wash.

Corresponding parts are designated by corresponding reference characters throughout the several views of the drawings.

### Detailed Description of the Invention

According to the process of the present invention, a semiconductor wafer is first washed with a washing agent prepared by diluting ammonia hydrogen peroxide with super deionized water (i.e., an ammonia hydrogen peroxide mixture or APM). This step removes abrasive and silicon debris, and the like. Following the washing step, the semiconductor wafer is acid pickled to remove and/or neutralize material remaining on the wafer after the washing step. The washing and acid pickling steps are performed by placing the semiconductor wafer in a cassette and immersing the cassette in vessels containing the washing agent and APM, respectively.

Acid pickling the wafer after washing has several benefits. Pickling neutralizes the ionized foreign material remaining on the wafer after washing so it will not react with residual ammonia from the wash to form salts. Because salts absorb water, they grow over time and can form defects in the epitaxial layer as will be explained in greater detail below. Further, the acid pickling removes and/or neutralizes alkaline material on the wafer, thereby reducing the chemical reactivity of the material. Because acids dissolve transition metals and alkali metals, such as iron, copper, nickel, zinc, chromium, aluminum, sodium, calcium, and potassium, acid pickling removes metals remaining on the wafer after washing.

Many different types of acid may be used for pickling. For instance, any inorganic or organic acid used during production of a semiconductor device may be used. Specifically, acetic acid, hydrochloric acid, hydrogen fluoride and citric acid may be used for acid pickling. In addition, the concentration of acid used for acid pickling is not particularly limited. Although an acid diluted 10-1600 times by weight with deionized water may be used, acid diluted to 50-800 times by weight is preferred.

The acid is usually rinsed off of the semiconductor wafer after acid pickling. However, when acid diluted to 1000 times by weight or more is used for acid pickling, the wafer does not require rinsing after pickling. Various rinsing methods may be used. For instance the rinse may be a quick-dump rinse, in which deionized water is introduced and discharged several times at high speed. Alternatively, an overflow rinse may be used. In an overflow rinse, deionized water is supplied from the bottom of a tank containing silicon wafers until it overflows for a predetermined period of time.

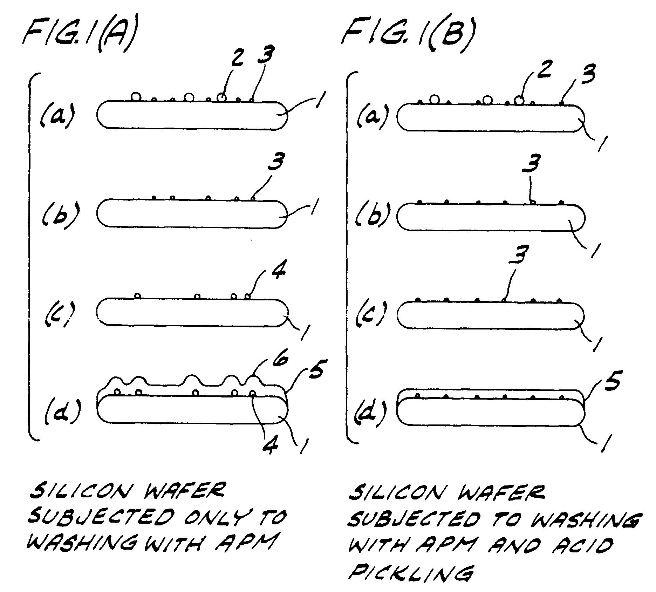

Referring to the drawings, Figs. 1(A) and 1(B) are schematics showing a semiconductor wafer, designated by the numeral 1, at various stages of production. Fig. 1(A) shows the condition of a semiconductor wafer washed with APM using the conventional washing method, and Fig. 1(B) shows a wafer washed with APM and acid pickled according to the present invention.

View (a) of Figs. 1(A) and 1(B) shows a typical semiconductor wafer 1 immediately following polishing. Large particles 2 of foreign material, such as abrasive and silicon debris, and small particles 3 of foreign material, such as ionized material, adhere to the surface of the wafer 1.

View (b) of Fig. 1(A) shows a wafer 1 which has been washed with APM only, and view (b) of Fig. 1(B) shows a wafer which has been washed with APM and subsequently acid pickled according to the present invention. As shown in view (b) of both figures, either method removes the large particles 2 of foreign material. Further, small particles 3 remain on the wafer 1 after either washing method.

View (c) of Figs. 1(A) and 1(B) shows the semiconductor wafers 1 after they have been stored for a period of time. As shown in view (c) of Fig. 1(A), when the wafer 1 is washed with APM only, the small foreign material particles 3 enlarge over time to form enlarged particles 4 of foreign material. The particles grow either by reacting with chemicals in the surrounding atmosphere or by absorbing water. Each enlarged particle 4 has a small particle 3 at its core. In contrast, as shown in view (c) of Fig. 1(B), when the wafer 1 is acid pickled after washing, the foreign material particles 3 are neutralized and do not grow.

View (d) of Figs. 1(A) and 1(B) shows the semiconductor wafer 1 after an epitaxial layer 5 is deposited on the wafer by chemical vapor deposition. As shown in Fig 1(A), when the semiconductor wafer 1 is washed with APM only, the enlarged foreign material particles 4 embedded in the epitaxial layer 5 form projections 6 which extend outward from the exterior surface of the epitaxial layer. Thus, the exterior surface is rough. However, when the wafer 1 is washed with APM and acid pickled according to the present invention, the exterior surface of the epitaxial layer 5 is smooth.

As shown by Fig. 1(A), when a semiconductor wafer 1 is only washed with APM before being stored for a long period of time, the small particles 3 of foreign material grow. In contrast, as shown by Fig. 1(B), when the wafer 1 is washed with APM and acid pickled, the small particles 3 do not grow, even when the wafer 1 is stored for as much as six months or more. Therefore, semiconductor wafers 1 processed according to the method of the present invention may be stored for a substantial period of time prior to depositing the epitaxial layer 5 on the wafer without significantly adversely affecting the exterior surface of the layer.

### Example

Although the present invention is described hereinbelow in more detail with reference to an example, the present invention is not limited to the example.

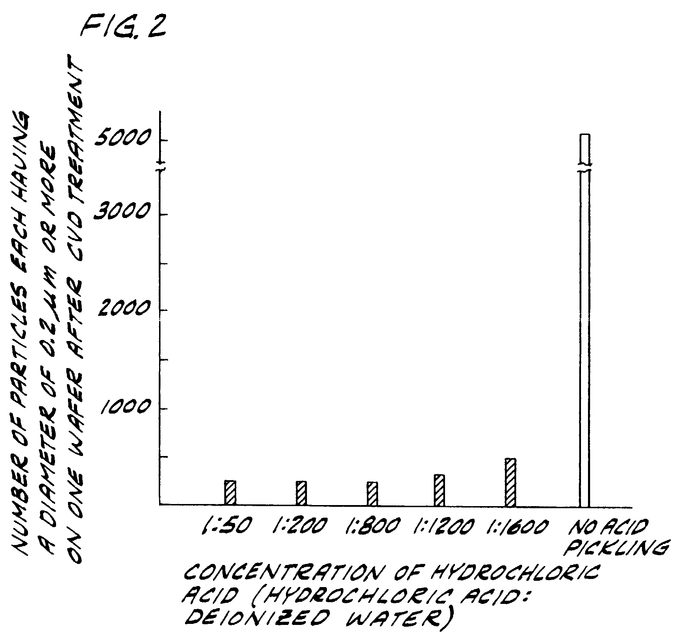

Polished semiconductor wafers were washed with a washing agent made by mixing one part by weight ammonia with two parts hydrogen peroxide and 50 parts super deionized water. After being washed, the wafers were acid pickled using various concentrations of hydrochloric acid. After the pickling step, epitaxial layers were deposited on the wafers using chemical vapor deposition, and the number of particles on the wafer which had a size 0.2 µm or larger were counted by a conventional laser-scattering particle counter. The results are shown in Fig. 2.

As illustrated by Fig. 2, when the semiconductor wafer was only washed with APM, more than 5000 particles having a size of 0.2µm or larger were counted. However, when the semiconductor wafer was washed with APM and acid pickled according to the present invention, fewer than about 600 particles of this size were counted regardless of the acid concentration used. As can be seen from these results, the present invention effectively reduces the size of foreign material particles on the wafers. Therefore, the present invention reduces semiconductor wafer defects caused by large particles being embedded in the epitaxial layer.

In view of the above, it will be seen that the several objects of the invention are achieved and other advantageous results attained.

As various changes could be made in the above constructions without departing from the scope of the invention, it is intended that all matter contained in the above description or shown in the accompanying drawings shall be interpreted as illustrative and not in a limiting sense.

## Claims

1. A method for washing a semiconductor wafer (1) after polishing and before depositing an epitaxial layer (5) on the wafer (1) by chemical vapor deposition to remove foreign material (2) and prevent growth of foreign material (4), the method comprising the steps of:
washing the semiconductor wafer (1) with a washing agent to remove foreign material (2) from the wafer (1); and
acid pickling the washed semiconductor wafer (1) in an acid to further remove foreign material (2, 3) and to neutralize residual foreign material (3) thereby minimizing the amount and size of foreign material (3, 4) embedded in the epitaxial layer (5).

2. A method according to claim 1, wherein the washing agent is prepared by diluting ammonia hydrogen peroxide with super deionized water.

3. A method according to claim 1 or claim 2, wherein the acid is selected from acetic acid, hydrochloric acid, hydrogen fluoride, and citric acid.

4. A method according to any one of claims 1 to 3, further comprising the step of rinsing the acid pickled semiconductor wafer (1) to remove residual acid from the wafer.

5. A method according to claim 4, wherein the wafer (1) is rinsed with deionized water.

6. A method according to any one of claims 1 to 5, further comprising the step of polishing the wafer (1) before washing the wafer (1).

7. A method according to any one of claims 1 to 6, further comprising the step of depositing an epitaxial layer (5) on the wafer (1) by chemical vapor deposition after acid pickling.
